Europäisches Patentamt

European Patent Office

Office européen des brevets

(19)

(11) Numéro de publication: **0 089 278**
**B1**

(12) **FASCICULE DE BREVET EUROPEEN**

(45) Date de publication du fascicule du brevet:
18.12.85

(51) Int. Cl.⁴: **H 01 L 27/14**

(21) Numéro de dépôt: 83400489.7

(22) Date de dépôt: 10.03.83

(54) Détecteur infra-rouge matriciel.

(30) Priorité: 12.03.82 FR 8204259

(43) Date de publication de la demande:
21.09.83 Bulletin 83/38

(45) Mention de la délivrance du brevet:
18.12.85 Bulletin 85/51

(84) Etats contractants désignés:
DE FR GB NL

(56) Documents cités:
FR - A - 2 012 024

INTERNATIONAL ELECTRON DEVICES MEETING,
TECHNICAL DIGEST, 4-6 décembre 1978, pages
510-512, Washington, USA, R.M. HOENDERVOOGT et
al.: "Hybrid InSb focal plane array fabrication"
IEEE TRANSACTIONS ON ELECTRON DEVICES, vol.
ED-29, no. 2, février 1982, pages 274-279, New York,
USA, M. LANIR et al.: "Performance of PV HgCdTe
arrays for 1-14-mum applications"

(73) Titulaire: **SOCIETE ANONYME DE
TELECOMMUNICATIONS, 40 avenue de New York,
F-75116 Paris (FR)**

(72) Inventeur: **Fleury, Joel, Jean-Marc, Sarzec Montamise,
F-86360 Chasseneuil Du Poitou (Vienne) (FR)**
Inventeur: **Maille, Jacques Henri Paul, 8, rue Claude
Pouillet, F-75017 Paris (Seine) (FR)**

(74) Mandataire: **Bloch, Robert et al, 39 avenue de Friedland,
F-75008 Paris (FR)**

ACTORUM AG

## Description

La présente invention concerne un détecteur infra-rouge matriciel, comprenant une matrice d'éléments infra-rouge notamment pour caméra, par exemple pour reconnaissance aérienne.

L'avantage de tels détecteurs à matrice réside dans le fait que l'adressage, ou le balayage, des éléments de la matrice s'effectue de manière électronique, et non plus mécaniquement par spot lumineux.

L'adressage consiste en fait, à l'aide de moyens électroniques de traitement, soit à intégrer les signaux délivrés par les éléments de la matrice, soit à commuter séquentiellement les éléments de la matrice sur un circuit de lecture des signaux délivrés. On conçoit donc que chacun des éléments de la matrice est connecté à ces moyens électroniques de traitement.

Pour obtenir les conditions de fonctionnement et de sensibilité les meilleures, la matrice d'éléments infra-rouge doit fonctionner à basse température.

Ainsi, pour des bandes spectrales de 3 à 5 μm ou de 8 à 12 μm, par exemple, la température optimale est de 77 K pour le détecteur en Hg Cd Te ou en In Sb.

On a donc proposé de disposer la matrice d'éléments sur une surface refroidie, dans une enceinte cryogénique.

On a alors commencé par réaliser le couplage des éléments de la matrice à des circuits électroniques de traitement, extérieurs à l'enceinte cryogénique, par des connexions. Mais cette solution présente des inconvénients dus à la longueur des lignes de connexion, dans lesquelles sont engendrés des bruits parasites, et à leur nombre qui provoque une charge thermique à cause des pertes en ligne. Par ailleurs, cette solution conduit à des modules de détection d'encombrement important, avec un grand nombre de soudures élémentaires.

On a ensuite proposé de disposer la matrice d'éléments infra-rouge et les circuits électroniques sur une même surface froide, à l'intérieur de l'enceinte cryogénique.

Mais les dimensions de cette surface sont forcément limitées par la puissance des refroidisseurs. Cette dernière solution a donc conduit à adopter, comme circuits électroniques de traitement, des circuits intégrés en silicium dont la maîtrise était acquise, permettant de rassembler sur une faible surface un nombre important de fonctions électriques, avec des éléments infra-rouge photovoltaïques, et non photoconducteurs, pour des raisons d'adaptation d'impédance, avec un très grand nombre d'éléments sensibles.

Deux solutions étaient alors possibles. Soit disposer la matrice d'éléments infra-rouge et le circuit silicium l'un à côté de l'autre, soit disposer la matrice au-dessus du circuit silicium.

La première de ces solutions n'apportait pas un avantage décisif, ni au plan de l'encombrement, ni au plan de la fabrication.

En adoptant la deuxième solution, on pouvait encore opter, soit pour une technologie dans laquelle l'éclairage de la matrice par les rayonnements s'effectue par la face portant les diodes détectrices, c'est-à-dire la face avant éloignée du circuit silicium, soit pour une technologie à éclairage par la face arrière, opposée à celle qui porte les diodes.

Dans la technologie à éclairage par la face arrière, on se heurte à la difficulté de réaliser une couche détectrice, monocristalline, par exemple en Hg Cd Te sur un substrat transparent aux rayonnements. Certes, dans ce cas, les éléments sensibles étant adjacents au circuit silicium, les liaisons par soudure froide entre les plots de connexion du circuit silicium et de la couche détectrice, par exemple en indium, sont facilement réalisables.

Dans la technologie à éclairage par la face avant, on perce des orifices dans la plaquette active monolithique pour réaliser, par couches minces, des liaisons entre les zones de la plaquette de dopage différent de celui du reste de la plaquette et définissant les diodes de la plaquette, et les plots d'entrée du circuit silicium, à l'arrière de la plaquette, créant ainsi des îlots de matériau détecteur, relativement décalés les uns par rapport aux autres pour permettre précisément les connexions sur le circuit silicium. Dans ce cas, le rapport entre la surface de la portion active et la surface totale de la plaquette, c'est-à-dire le coefficient d'occupation, est faible. En outre, cette structure en îlots est très fragile. Enfin, et tout comme dans la technologie à éclairage par la face arrière, subsiste la difficulté de réaliser un grand nombre de connexions.

Ces inconvénients ne sont d'ailleurs pas éliminés si, comme l'enseigne, par exemple, le brevet français N° 2012024, on diffuse, dans une plaquette de semi-conducteur, de l'un des deux types p et n, percée d'orifices traversants des zones de l'autre des deux types s'étendant le long des parois des orifices et destinées à recevoir des broches de connexion électrique.

La présente invention a pour but de pallier les inconvénients de cette technologie à éclairage par la face avant.

A cet effet, la présente invention concerne un détecteur infra-rouge matriciel comprenant:

— une première plaquette semi-conductrice d'un premier type de conductivité et comportant des zones de type opposé s'étendant depuis la face de cette plaquette destinée à être exposée aux rayonnements infra-rouge et définissant des jonctions pn formant une matrice de détecteurs élémentaires,

— une deuxième plaquette semi-conductrice, vers laquelle est tournée la face opposée de la première plaquette, comprenant au moins un circuit intégré de traitement des signaux électriques délivrés par les détecteurs élémentaires de la matrice, et

— des plots de soudure répartis sur la face de la première plaquette tournée vers la deuxième plaquette et connectant notamment lesdites zones de la première plaquette à la face de la deuxième plaquette tournée vers la première plaquette,

— lesdites zones de la première plaquette s'étendant à travers l'épaisseur de la première plaquette sous la forme de canaux comprenant un espace de détection, s'étendant depuis la face destinée à être exposée aux rayonnements, un espace de liaison s'étendant depuis l'autre face de la première plaquette et une zone médiane de couplage électrique desdits espaces de détection et de liaison.

Grâce à l'invention, on a donc pu reporter les contacts des plots de soudure avec les zones de l'autre type de la première plaquette massive, de la face avant de celle-ci, celle qui est exposée aux rayonnements, à la face arrière. Cette caractéristique présente deux avantages. Le premier, qui est du reste celui de la technologie non monolithique à éclairage par la face arrière, réside dans le fait que les connexions entre la plaquette de détection et la plaquette de traitement sont les plus courtes possibles. Le second, le plus important, réside dans le fait que ces connexions peuvent être faites collectivement en une seule opération.

On remarquera que la demanderesse a réalisé son invention en partant, d'une part, de détecteurs photovoltaïques et de circuits de traitement silicium et, d'autre part, de détecteurs refroidis dans une enceinte cryogénique. Il est clair qu'elle n'entend pas limiter la portée de son invention à de tels détecteurs, et que celle-ci s'étend à tous détecteurs à éclairage par la face avant dont les connexions avec les circuits de traitement sont reportés sur la face arrière. Il n'est en effet pas utile pour que le progrès procuré par cette invention soit déjà significatif que celle-ci s'applique à des détecteurs refroidis, de grande sensibilité, ou à des détecteurs à circuits de traitement silicium. L'invention se suffit à elle-même dès lors que les jonctions assurent simultanément les fonctions de détection et de liaison avec la face arrière.

L'invention sera mieux comprise à la lecture de la description suivante d'une forme de réalisation préférée du détecteur de l'invention, en référence aux dessins annexés, sur lesquels:

— les fig. 1 à 5 représentent la plaquette de détection et de liaison du détecteur de l'invention, dans ses différentes phases de fabrication, et

— la fig. 6 représente une vue schématique du détecteur de l'invention avec la plaquette de détection et de liaison des fig. 1 à 5.

Décrivons tout d'abord les différentes phases du procédé de fabrication de la plaquette de détection.

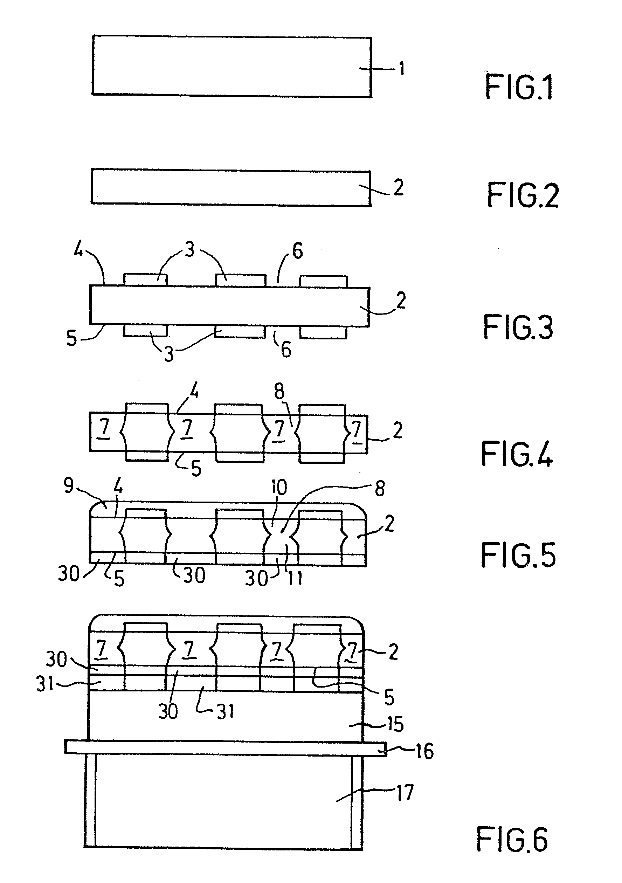

On part d'un substrat massif 1, par exemple en Hg Cd Te (fig. 1), qui est un matériau semi-conducteur bien approprié notamment pour la détection d'objets ou de paysages dans les bandes spectrales de 3 à 5 µm et de 8 à 12 µm, bien que l'invention ne soit pas limitée à un tel matériau, le substrat 1 est plus précisément de type p, bien qu'on eût également pu prendre un substrat de type n.

On procède ensuite à un amincissement du substrat 1, par des moyens connus, et par exemple par polissage, pour obtenir une plaquette 2, en l'espèce de 20 à 30 µm d'épaisseur (fig. 2).

On dépose une couche de masquage, dans le cas présent en ZnS, sur les deux faces 4 et 5 de la plaquette 2, et on procède à des ouvertures dans ces deux couches pour ménager, sur chacune des faces, des bandes de masquage 3 disposées de façon matricielle et, entre ces bandes, des fenêtres 6 dans une configuration de mosaïque, les fenêtres, et donc les bandes de masquage, des deux faces étant respectivement les unes au droit des autres (fig. 3).

On procède, à partir des fenêtres 6, à une diffusion de type n simultanément depuis les deux faces 4 et 5 de la plaquette 2, pour obtenir des zones 7 de type n s'étendant de la face 4 à la face 5 de la plaquette 2 (fig. 4). Ces zones 7 de type n se présentent sous la forme de canaux présentant une portion médiane 8, due à la technique de diffusion «planar» mise en œuvre en l'occurrence.

Bien entendu, si on était parti d'un substrat de type n, on aurait procédé ensuite à une diffusion de type p.

La face 4 de la plaquette 2 est celle qui est destinée à être exposée aux rayonnements infra-rouge à détecter.

Cette détection est réalisée par la mosaïque des photodiodes élémentaires créées par les zones 7 de type n dans le substrat de type p de la plaquette 2.

Bien que la plaquette 2 décrite jusqu'ici soit sensiblement symétrique par rapport à son plan médian, on appellera sa face 4 la face avant, et donc sa face 5, la face arrière, d'une part, parce que c'est la face 4 qui sera exposée aux rayonnements et, d'autre part, parce que les jonctions détectrices s'étendent de toutes façons depuis cette face 4, par analogie avec le vocabulaire employé en liaison avec la technologie classique à éclairage par la face avant.

Outre le fait que le plan des jonctions ainsi définies est sensiblement parallèle à la direction des rayonnements à recevoir, ces jonctions sont donc remarquables par le fait qu'elles s'étendent de la face avant 4 à la face arrière 5 de la plaquette 2.

On recouvre ensuite la face avant 4 de la plaquette 2 d'une couche de protection, ou de passivation, 9 (fig. 5). Puis on dépose dans les fenêtres 6 de la face arrière 5, le long des zones de type n, de façon collective en une seule opération, une couche de métallisation, de préférence en indium, pour réaliser des plots 30 de connexion des zones de type n des photodiodes, destinés à être reliés par soudure froide avec des plots d'entrée correspondants 31 d'un circuit intégré silicium de traitement des signaux délivrés par les jonctions pn de la plaquette 2 (fig. 5).

Quant au seul plot de connexion des zones de type p de la plaquette, à relier avec un plot correspondant du circuit silicium de traitement, il peut être formé en n'importe quel endroit du massif de la plaquette 2, mais de préférence, sur la face arrière 5.

Les zones de type n, en définitive, sont composées d'un premier espace de détection 10, formé par la diffusion depuis la face avant 4, et un deuxième espace de liaison 11, formé par la diffusion depuis la face arrière 5, ces deux espaces étant reliés par la portion médiane 8 de couplage électrique.

Les caractéristiques des photodiodes ainsi obtenues par diffusion doubles faces sont tout à fait similaires à celles de photodiodes obtenues par diffusion simple face, grâce à la faible épaisseur de la plaquette 2, permettant d'obtenir des surfaces de jonction comparables à celles des jonctions diffusées par une seule face.

En ce qui concerne le coefficient d'occupation, il n'est limité que par les caractéristiques électroniques du matériau de départ, Hg Cd Te, et donc par les possibilités de diffusion des porteurs électriquees. Il peut atteindre 70% pour des surfaces sensibles carrées exposées aux rayonnements de 50 μm de côté.

Il reste ensuite, disposant de la plaquette de détection, et de liaison, à prendre une deuxième plaquette 15 de silicium de traitement des signaux délivrés par les photodiodes de la première plaquette 2, qui ne fait pas l'objet de la présente invention, au demeurant parfaitement connue de l'homme de métier, et qui ne sera donc pas décrite plus avant ici, à former les plots de connexion en indium 31 destinés à être reliés aux plots 30 de la face arrière 5 de la plaquette 2, à relier les plots des deux plaquettes deux à deux par soudure froide, pour connecter les zones 7 de type n et le massif de type p de la plaquette 2 au circuit de la plaquette 15, et à disposer les deux plaquettes 2 et 15 sur une surface 16 refroidie, dans une enceinte cryogénique 17 (fig. 6).

On notera que grâce au bon transfert thermique de la plaquette silicium 15, le refroidissement de la plaquette 2 de détection et de liaison, séparée de la surface froide 16 par la plaquette 15, reste quand même assuré.

Enfin, si la liaison entre les plaquettes 2 et 15 s'effectue par un très grand nombre de connexions, la sortie de la plaquette silicium s'effectue par un nombre beaucoup plus faible de plots de sortie, non représentés.

## Revendications

1. Détecteur infra-rouge matriciel comprenant:
— une première plaquette semi-conductrice (2), d'un premier type de conductivité et comportant des zones (7) de type opposé s'étendant depuis la face (4) de cette plaquette destinée à être exposée aux rayonnements infra-rouge et définissant des jonctions pn formant une matrice de détecteurs élémentaires,
— une deuxième plaquette semi-conductrice (15), vers laquelle est tournée la face opposée (5) de la première plaquette, comprenant au moins un circuit intégré de traitement des signaux électriques délivrés par les détecteurs élémentaires de la matrice, et
— des plots de soudure (30) répartis sur la face (5) de la première plaquette tournée vers la deuxième plaquette et connectant notamment lesdites zones (7) de la première plaquette à la face de la deuxième plaquette tournée vers la première plaquette,
— lesdites zones (7) de la première plaquette s'étendant à travers l'épaisseur de la première plaquette sous forme de canaux comprenant un espace de détection (10), s'étendant depuis la face (4) destinée à être exposée aux rayonnements, un espace de liaison (11) s'étendant depuis l'autre face (5) de la première plaquette et une zone médiane (8) de couplage électrique entre lesdits espaces de détection et de liaison.

2. Détecteur infra-rouge selon la revendication 1, dans lequel la première plaquette est un semi-conducteur de type p et lesdites zones des zones diffusées de type n.

3. Détecteur infra-rouge selon l'une des revendications 1 et 2, dans lequel la première plaquette est un semi-conducteur de type n et lesdites zones sont des zones diffusées de type p.

4. Détecteur infra-rouge selon l'une des revendications 1 à 3, dans lequel la première plaquette esten Hg Cd Te.

5. Détecteur infra-rouge selon l'une des revendications 1 à 4, dans lequel la deuxième plaquette est en silicium.

## Patentansprüche

1. Matrix-Infrarotdetektor enthaltend:
— ein erstes Halbleiterplättchen (2) eines ersten Leitungstyps, das Zonen (7) des entgegengesetzten Leitungstyps aufweist, die sich von der der Infrarot-Strahlung auszusetzende Seite (4) dieses Plättchens aus erstrecken und pn-Übergänge definieren, die eine Matrix von Elementar-Detektoren bilden,
— ein zweites Halbleiterplättchen (15), dem die gegenüberliegende Seite (5) des ersten Plättchens zugewandt ist, das mindestens eine integrierte Schaltung für die Behandlung der von den Elementar-Detektoren der Matrix gelieferten elektrischen Signale umfasst,
— Lötkontaktstellen (30), die auf der dem zweiten Plättchen zugewandten Seite (5) des ersten Plättchens verteilt sind und besonders die Zonen (7) des ersten Plättchens mit der dem ersten Plättchen zugewandten Seite des zweiten Plättchens verbinden,
— wobei diese Zonen (7) des ersten Plättchens sich durch die Dicke des ersten Plättchens in Form von Kanälen erstrecken, die einen Detektionsraum (10), der sich von der der Strahlung auszusetzenden Seite (4) aus erstreckt, einen Anschlussraum (11), der sich von der anderen Seite (5) des ersten Plättchens aus erstreckt, und eine Mittelzone (8) zum elektrischen Verbinden zwischen den Detektions- und Anschlussräumen umfassen.

2. Infrarotdetektor nach Anspruch 1, bei dem das erste Plättchen ein Halbleiter vom Typ p ist, während die Zonen Diffusionszonen vom Typ n sind.

3. Infrarotdetektor nach Anspruch 1, bei dem das erste Plättchen ein Halbleiter vom Typ n ist, während die Zonen Diffusionszonen vom Typ p sind.

4. Infrarotdetektor nach einem der Ansprüche 1 bis 3, bei dem das erste Plättchen aus Hg Cd Te besteht.

5. Infrarotdetektor nach einem der Ansprüche 1 bis 4, bei dem das zweite Plättchen aus Silicium besteht.

## Claims

1. Matrix infrared detector comprising:
— a first semi-conductor wafer (2), of a first conductivity type and having zones (7) of the opposite type extending from the face (4) of this wafer adapted to be exposed to the infrared radiations, and defining pn junctions forming a matrix of elementary detectors,
— a second semi-conductor wafer (15) towards which faces the opposite face (5) of the first wafer, comprising at least one integrated circuit for processing the electrical signals delivered by the elementary detectors of the matrix, and
— solder studs (30) disposed along the face (5) of the first wafer facing the second wafer and connecting in particular said zones (7) of the first wafer to the face of the second wafer facing the first wafer,
— said zones (7) of the first wafer extending throughout the thickness of the first wafer in the form of canals comprising a detection space (10), extending from the face (4) adapted to be exposed to the radiations, a connection space (11) extending from the other face (5) of the first wafer and an intermediate zone (8) for electrical coupling between said detection and connection spaces.

2. Infrared detector of Claim 1, wherein the first wafer is a semi-conductor of p type and said zones are diffused zones of n type.

3. Infrared detector of Claim 1, wherein the first wafer is a semi-conductor of n type and said zones are diffused zones of p type.

4. Infrared detector of one of Claims 1 to 3, wherein the first wafer is made of Hg Cd Te.

5. Infrared detector of one of Claims 1 to 4, wherein the second wafer is made of silicon.

FIG.1

FIG.2

FIG.3

FIG.4

FIG.5

FIG.6